(19) Europäisches Patentamt

European Patent Office

Office européen des brevets

(11) EP 0 566 434 B1

(12) **FASCICULE DE BREVET EUROPEEN**

(45) Date de publication et mention
de la délivrance du brevet:
**22.05.1996 Bulletin 1996/21**

(51) Int Cl.6: **H01S 3/1055**, H01S 3/133

(21) Numéro de dépôt: **93400702.2**

(22) Date de dépôt: **18.03.1993**

(54) **Procédé de réglage d'une source lumineuse continûment syntonisable**

Verfahren zum Justieren einer kontinuierlich abstimmbaren Lichtquelle

Adjustment method for a continuously tunable light-source

(84) Etats contractants désignés:
**DE GB**

(30) Priorité: **13.04.1992 FR 9204514**

(43) Date de publication de la demande:
**20.10.1993 Bulletin 1993/42**

(73) Titulaire: **FRANCE TELECOM**
**F-75015 Paris (FR)**

(72) Inventeurs:
- **Favre, François**
  **F-22700 Perros Guirec (FR)**
- **Le Guen, Daniel**
  **F-22700 Louannec (FR)**

(74) Mandataire: **Phélip, Bruno et al**
**c/o Cabinet Harlé & Phélip**
**21, rue de La Rochefoucauld**
**F-75009 Paris (FR)**

(56) Documents cités:
**FR-A- 2 595 013**

- ELECTRONICS LETTERS vol. 27, no. 2, 17 **Janvier 1991, ENAGE GB pages 183 - 184 F.FAVRE ET AL. '82 NM OF CONTINUOUS TUNABILITY FOR AN EXTERNAL CAVITY SEMICONDUCTOR LASER'**

## Description

L'invention concerne une source lumineuse syntonisable à cavité étendue et un procédé de réglage d'une telle source.

Les sources lumineuses continûment syntonisables peuvent recevoir de nombreuses applications, notamment en télécommunication optique, par exemple dans des systèmes de communication multicanaux cohérents, pour la réalisation de mesures spectroscopiques, des caractérisations de laser ou d'amplificateur optique.

Une source lumineuse continûment accordable a été décrite dans le brevet français FR-2 595 013, et plus récemment dans un article des inventeurs de la présente demande publié dans la revue "Electronics Letters" du 17 Janvier 1991 (Vol. 27, N° 2, pages 183-184).

La source décrite dans ces publications comporte un laser semi-conducteur, dont une première face porte un revêtement antiréfléchissant.

La deuxième face de ce laser forme une cavité résonnante avec un réseau de diffraction.

Le déplacement de ce réseau, combiné en rotation et en translation, dans des conditions déterminées, permet d'obtenir la syntonisation continue de la source.

Ces conditions de déplacement du réseau doivent être respectées avec une grande précision, et nécessitent le réglage d'éléments mécaniques après le montage complet de la source, régulièrement et même, de préférence, fréquemment lors de son utilisation.

Jusqu'à présent, la réalisation de ces réglages était considérée comme particulièrement délicate, et aucune méthode satisfaisante n'avait été mise au point pour permettre un usage simple et courant d'une telle source.

L'objet de la présente invention est de remédier à ces inconvénients.

A cet effet, l'invention concerne un procédé de réglage d'une source lumineuse à cavité étendue continûment syntonisable,

ladite source comprenant :

- un laser commandé par un courant injecté, ayant un axe optique et une première et une deuxième faces, la première face ayant un faible coefficient de réflexion ;
- un réseau de diffraction placé sur l'axe du laser, du côté de la première face, translatable le long de l'axe du laser et orientable autour d'un axe coupant l'axe du laser à angle droit, et formant, avec la deuxième face du laser, la cavité étendue ;
- un bras rigidement lié au réseau ayant une extrémité mobile qui est en contact permanent avec un plan de glissement perpendiculaire à l'axe optique du laser ;
- des moyens de réglage fin du plan de glissement par rapport au laser ;

la syntonisation de la source étant obtenue par un déplacement du réseau.

Selon l'invention, :

a) on fait un réglage approximatif de l'orientation et de la position du plan de glissement ;
b) on fait tourner le réseau et, simultanément, on mesure la puissance d'émission de la source par rapport au courant injecté en fonction de l'orientation du réseau ;
c) on compte le nombre de sauts de la puissance d'émission par rapport au courant injecté au cours de la rotation du réseau, chaque saut étant affecté d'un signe fonction de son sens ;
d) on agit sur les moyens de réglage fin en fonction du résultat du comptage ;
e) on répète les opérations b), c) et d), jusqu'à ce que le résultat du comptage soit nul.

De préférence, on compte ensuite le nombre de sauts, indépendamment de leur sens, puis on agit sur les moyens de réglage fin, jusqu'à ce que le nombre de sauts soit nul.

Le procédé de l'invention présente, de préférence, les caractéristiques suivantes, isolément ou en combinaison :

- la mesure de la puissance d'émission est faite par prélèvement d'une partie du flux lumineux émis ;
- la puissance d'émission est asservie à une valeur constante, et l'on mesure le courant injecté commandant le laser ;
- le réglage est automatisé, les moyens de réglage fin sont actionnés automatiquement à partir de la puissance d'émission de la source par rapport au courant injecté.

L'invention concerne également une source lumineuse permettant la mise en oeuvre simple du procédé de l'invention.

Elle comporte :

- un laser commandé par un courant injecté, ayant un axe optique, et une première et une deuxième faces, la première face ayant un faible coefficient de réflexion ;
- un réseau de diffraction placé sur l'axe du laser, du côté de la première face, translatable le long de l'axe du laser et orientable autour d'un axe coupant l'axe du laser à angle droit, et formant, avec la deuxième face du laser, la cavité étendue ;
- un bras rigidement lié au réseau ayant une extrémité mobile qui est en contact permanent avec un plan de glissement perpendiculaire à l'axe optique du laser ;
- des moyens de réglage fin du plan de glissement par rapport au laser ;

la syntonisation de la source étant obtenue par un déplacement du réseau.

Selon l'invention, la source lumineuse comporte :

- des moyens de prélèvement d'une partie du flux émis ;
- un photodétecteur recevant le flux prélevé ;
- des moyens de traitement du signal électrique du photodétecteur ;
- des moyens de commande des moyens de réglage fin à partir d'un signal élaboré par les moyens de traitement.

Lors du réglage, les moyens de traitement asservissent la puissance d'émission à une valeur fixe et :

a) engendrent le déplacement du réseau ;
b) mesurent simultanément la puissance d'émission de la source par rapport au courant injecté ;
c) comptent le nombre de sauts de la puissance d'émission par rapport au courant injecté au cours de la rotation du réseau, chaque saut étant affecté d'un signe fonction de son sens ;
d) agissent sur les moyens de réglage fin en fonction du résultat du comptage ;
e) reproduisent les opérations a) à d), jusqu'à ce que le résultat du comptage soit nul ;
f) comptent le nombre de sauts, indépendamment de leur sens ;
g) agissent sur les moyens de commande, jusqu'à ce que le nombre de sauts soit nul.

Un mode de réalisation de l'invention sera décrit ci-après en détail, en référence aux dessins annexés, dans lesquels :

- la Figure 1 est un schéma de principe général d'une source à cavité étendue syntonisable ;
- la Figure 2 est un schéma indicatif représentant le gain de la source en fonction de la longueur d'onde ;
- la Figure 3 est une représentation de la longueur d'onde d'émission d'une source à cavité étendue en fonction de l'orientation du réseau autour d'un axe fixe ;
- les Figures 4 et 5 représentent chacune le gain d'une source à cavité étendue continûment syntonisable pour deux positions et orientations du réseau ;
- la Figure 6 est une représentation schématique du déplacement du réseau lors de la variation de la syntonisation ;
- la Figure 7 est une représentation de la source selon l'invention.

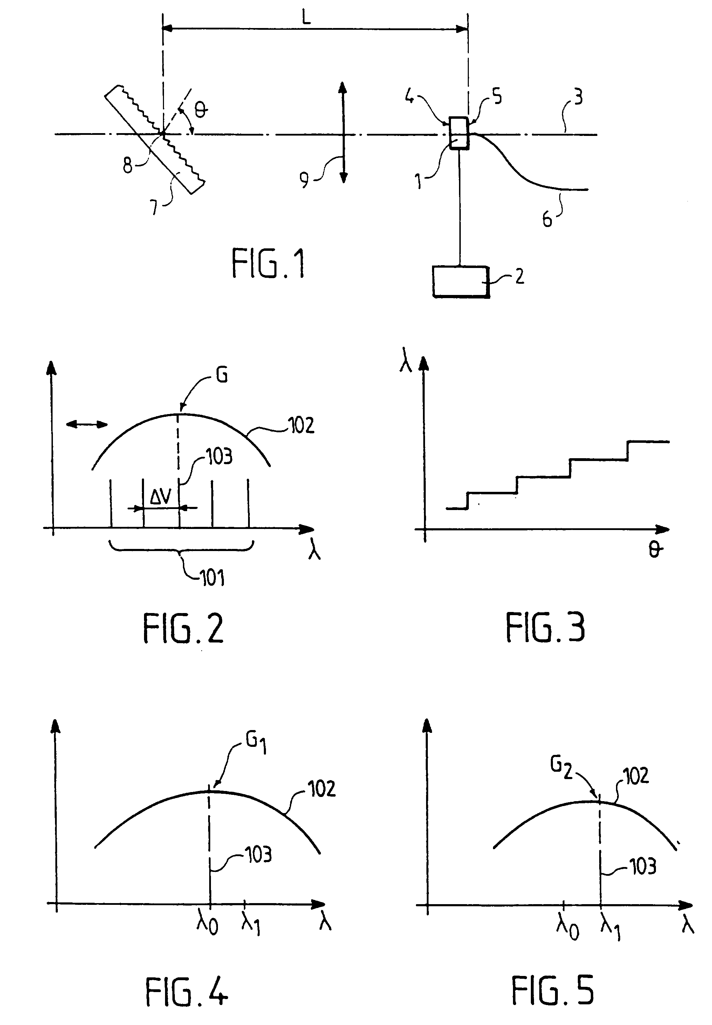

La Figure 1 représente une source lumineuse à cavité étendue. Un laser 1 commandé par une source de courant 2 a un axe optique 3. Il comporte une première face 4 faiblement réfléchissante, et une deuxième face 5 couplée à une fibre optique 6.

Le laser 1 est un laser semi-conducteur et la première face 4 porte un revêtement multicouche antiréfléchissant.

Un réseau de diffraction 7 est placé sur l'axe optique 3 du laser 1 du côté de la première face 4 du laser. Ce réseau forme, avec la face 5 du laser 1, une cavité étendue de longueur optique équivalente L'.

Cette longueur optique équivalente L' dépend directement de la distance géométrique L entre le réseau et la deuxième face 5 du laser 1.

Le réseau 7 est orientable autour d'un axe 8 coupant l'axe 3 du laser à 90°.

Un système optique 9 est éventuellement interposé entre le laser 1 et le réseau 7, de manière à collimater le flux lumineux émis par le laser et à assurer un fonctionnement convenable du réseau 7.

La cavité formée par la face 5 du laser 1 et le réseau 7, pour l'instant assimilé à un miroir, résonne pour des modes, dont l'écartement en fréquence est donné par la formule :

$$\Delta\upsilon = c/2L'$$

où c représente la vitesse de la lumière et L' la longueur du résonateur. Ces modes résonnants sont centrés sur les fréquences ou longueurs d'onde, représentées globalement par la référence 101 sur les Figures 2 à 5.

Par ailleurs, le réseau 7 a une réponse en fonction de la longueur d'onde ou de la fréquence lumineuse, représentée par la référence 102 sur les Figures 2 à 5. Cette courbe est centrée sur la longueur d'onde donnée par la formule :

$$\lambda = 2a \sin \Theta$$

où a représente le pas du réseau et $\Theta$ l'angle d'incidence du faisceau lumineux, c'est-à-dire l'angle de la normale au réseau avec l'axe optique 3 du laser 1.

En pratique, dans un tel dispositif, celui des modes de la cavité résonnante qui bénéficie du plus fort gain par l'effet du réseau 103 détermine la longueur d'onde $\lambda$ d'émission de la source.

Ainsi, pour une longueur optique donnée L' de la cavité, cette longueur d'onde $\lambda$ d'émission de la source varie de manière discontinue, telle que représentée sur la Figure 3, lors d'une variation continue de l'angle $\Theta$ d'orientation du réseau 7.

En effet, la rotation du réseau 7 produit un déplacement de sa courbe de réponse 102, parallèlement à l'axe des $\lambda$ qui produit la prééminence successive des différents modes 101.

Dans une source continûment syntonisable, simultanément à la rotation du réseau 7 qui produit le déplacement de la courbe 102, on modifie la longueur optique L' de la cavité résonnante, de telle sorte que le mode privilégié 103 suive le déplacement de la courbe 102.

Le déplacement conjoint est obtenu, par combinaison des formules indiquées plus haut, lorsque la condition L' = ma sin $\Theta$ est respectée (où m est un nombre entier).

Alors, tel que représenté sur les Figures 4 et 5, le déplacement du réseau 7 se fait d'une première position (Figure 4) à une deuxième (Figure 5). La réponse 102 du réseau 7 et le mode résonnant 103 de la cavité étendue se déplace simultanément, la longueur d'onde d'émission de la source passe de $\lambda_0$ à $\lambda_1$ sans modification importante du gain ($G_1 \simeq G_2$).

Il est connu que le respect de cette condition peut être obtenu en fixant rigidement le réseau 7 sur un bras mobile 10, dont une extrémité 11 est maintenue en contact permanent avec un plan de glissement 12 perpendiculaire à l'axe optique 3.

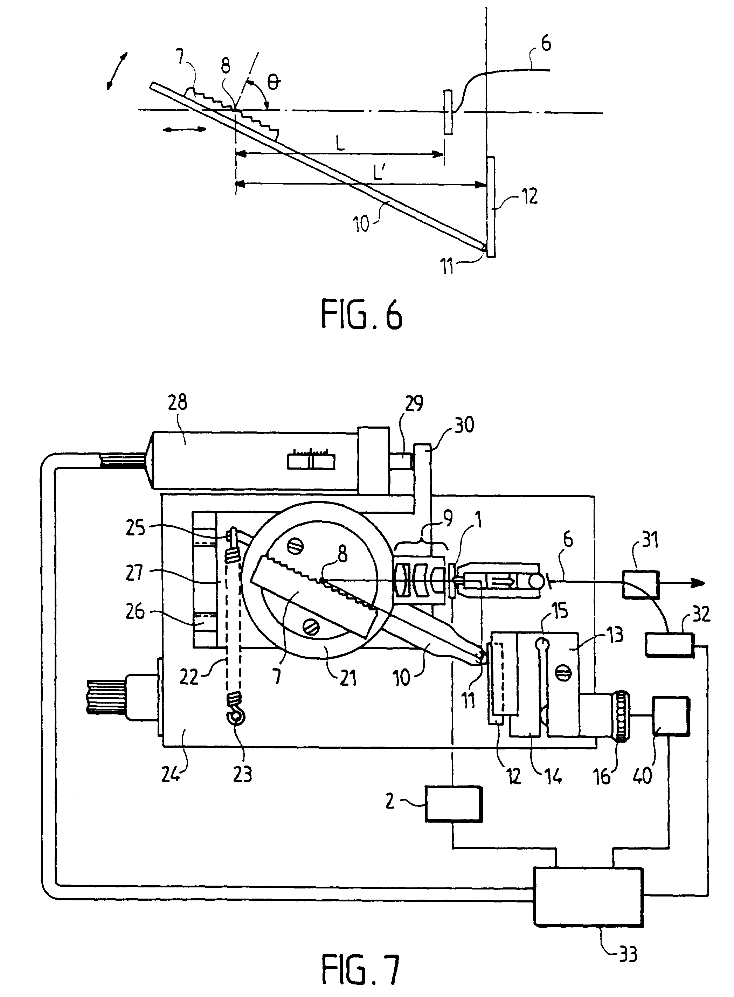

L' est alors la distance entre l'intersection du réseau 7 avec l'axe 3 du laser 1 et le plan de glissement 12 (Figure 6).

Lorsque ce plan de glissement 12 est convenablement positionné, à la fois en orientation et en position par rapport à l'axe optique 3, la relation mentionnée plus haut entre l'angle d'orientation $\Theta$ du réseau 7 et la longueur L de la cavité résonnante est respectée.

Le réglage précis de cette orientation et/ou de cette position du plan de glissement 12 est délicat à réaliser, et aucune proposition n'avait été faite jusqu'à ce jour pour faciliter ce réglage.

Alors que jusqu'à présent, il était d'usage d'observer la variation de la longueur d'onde d'émission de la source par rapport à l'angle d'orientation du réseau, tel que représenté sur la Figure 3, jusqu'à l'obtention par approximations successives d'une syntonisation continue, il a été constaté de manière surprenante que la mesure de la puissance d'émission de la source, par rapport au courant et non de sa longueur d'onde, en fonction de l'orientation du réseau, permet d'effectuer ce réglage facilement et dans de bonnes conditions.

Ainsi, on fait tout d'abord un réglage approximatif de l'orientation de la position du plan de glissement. Ce réglage approximatif peut résulter de l'assemblage mécanique lui-même. On peut également envisager des réglages grossiers, fixés une fois pour toutes, lors de la construction de la source.

La source comporte des moyens de réglages fin 13 agissant sur l'orientation et/ou sur la position du plan de glissement 12.

Ces moyens de réglage fin 13 comportent un élément 14, mobile en rotation autour d'un axe 15 par l'action d'une vis micrométrique 16. Cet élément 14 porte le plan de glissement 12.

La procédure de réglage de la source permettant de satisfaire la condition d'accordabilité continue est la suivante.

On déplace le réseau 7 et on mesure, éventuellement on enregistre la puissance d'émission de la source par rapport au courant injecté en fonction de la position du réseau.

En effet, on a constaté que la puissance d'émission de la source, ou plus précisément son rapport au courant injecté par la source de courant 2, présente des sauts lors du passage de la résonance de la cavité d'un mode à un autre.

On cherche donc au cours de la procédure de réglage à positionner le plan 12, de telle sorte que ces sauts n'existent plus.

Pour cela, on mesure le sens et le nombre de sauts de la puissance d'émission par rapport au courant injecté lors du mouvement du réseau 7.

On compte algébriquement le nombre de sauts en affectant chacun d'eux d'un signe fonction de son sens.

Puis on agit sur les moyens de réglage fin en fonction du résultat de ce comptage.

En effet, il a été prévu par la théorie et constaté par l'expérience que le sens des sauts, c'est-à-dire leur signe, détermine le sens du déplacement du plan de glissement 12 qu'il faut produire pour diminuer l'amplitude de ces sauts.

Après avoir réalisé ce réglage, on recommence les opérations précédentes, on fait tourner le réseau, on mesure le signe et le nombre de sauts, on en fait la somme algébrique, et l'on procède à un nouveau réglage, cela jusqu'à ce que le résultat du comptage soit nul.

Toutefois, ce réglage peut conduire à un mode de résonnance multimode, dans lequel les sauts d'une amplitude donnée dans un sens sont compensés, dans le cumul, par des sauts de même amplitude dans l'autre sens.

Pour éviter le réglage de la source sur une résonnance multimode, il est alors souhaitable de cumuler également les valeurs absolues du nombre de sauts, et d'agir sur les moyens de réglage pour minimiser et même rendre nul ce cumul. Ce nouveau réglage, s'il est nécessaire, n'affecte pas le réglage précédent.

Alors, on obtient, par rotation et déplacement du réseau 7, une source continûment syntonisable.

On a, jusqu'à présent, indiqué que le réglage de la source est fait en considérant sa puissance d'émission par rapport au courant injecté. En effet, ces deux paramètres sont interdépendants.

En pratique, on préfère maintenir la puissance d'émission constante par un asservissement et mesurer le courant injecté.

On peut également fixer le courant injecté et mesurer la puissance d'émission.

Les courbes représentant respectivement le courant injecté en fonction de l'orientation et de la position du réseau 7 à puissance lumineuse constante et la puissance lumineuse, également en fonction de l'orientation et de la position du réseau 7, sont complémentaires.

Le procédé de réglage de la source lumineuse syntonisable à cavité étendue peut avantageusement être automatisé, les moyens de réglage fin 13 sont alors actionnés à partir de la puissance d'émission par rapport au courant injecté.

La source, représentée sur la Figure 7, comporte un laser 5 commandé par une source électrique 2, un réseau 7, un système optique 9.

Le plan de glissement 12 est fixé sur l'élément 14 des moyens de positionnement 13 actionnés par la vis micrométrique 16.

Le réseau 7 est porté par une platine tournante 21 solidaire du bras 10. Un ressort 22 est fixé d'une part par l'intermédiaire d'une attache 23 à la base 24 de la source, et à son autre extrémité à un doigt 25 fixé à la platine tournante 21.

L'action du ressort 22 maintient l'extrémité 11 du bras 10 en contact avec le plan 12. La platine tournante 21 est elle-même fixée sur un mouvement de translation, comportant une embase 26 fixée sur la base 24 et un élément mobile 27 qui porte la platine tournante 21.

Le moteur 28 commandant la tige de vérin 29 est susceptible de produire le déplacement des moyens de translation 26, 27 en appuyant sur le doigt 30, solidaire de l'élément de translation 27.

On comprend qu'ainsi le moteur 28, produisant le déplacement de l'élément de translation 27, entraîne le réseau 7, modifiant alors la longueur de la cavité résonnante de la source. Simultanément, le bras 10, en appui sur le plan de référence 12, produit la rotation du réseau 7 autour de son axe 8 et par là, le déplacement de la courbe de transfert 102.

Le réglage fin de la source, c'est-à-dire de la position du plan de glissement 12, est avantageusement automatisé.

A cet effet, un séparateur 31 prélève une partie du flux émis par la source et l'adresse sur le photodétecteur 32. Le signal électrique produit par ce photodétecteur est transmis à une unité de traitement 33 qui, d'une part, commande la source électrique 2 et détermine le courant injecté dans le laser, en telle sorte que l'intensité du flux lumineux par la source soit constante, quelle que soit la position du réseau 7.

D'autre part, l'unité de traitement 33 est propre à commander des opérations d'étalonnage selon lesquelles, par l'action du moteur 28, le déplacement en translation et en rotation du réseau 7 est produit, la mesure du courant injecté par la source 2 en fonction de l'orientation du réseau 7 est effectuée, le signe et le nombre de sauts du courant injecté sont comptés et algébriquement cumulés, et un signal est adressé par les moyens de traitement 33 en fonction du résultat de ce cumul à l'unité de commande 40 de la vis micrométrique 16, de manière à minimiser le cumul du nombre de ces sauts.

Tel que cela a été indiqué plus haut lors de la description du procédé, les moyens de traitement 33 effectuent avantageusement le cumul de la valeur absolue des nombres de sauts, de manière à commander la vis micrométrique 16 par l'intermédiaire des moyens de commande 40, et à éviter une résonnance multimode de la cavité.

L'invention propose donc un procédé de réglage particulièrement simple d'une source syntonisable.

A titre indicatif, soulignons qu'il a été réalisé une source réalisant une accordabilité en longueur d'onde sans saut de mode sur 82 nanomètres, avec un laser semi-conducteur émettant autour de 1540 nanomètres.

Le coefficient de réflexion de la première face 4 du laser est inférieur de $10^{-3}$ entre 1500 et 1580 mm.

Le coefficient de réflexion de la deuxième face du laser 5 est de l'ordre de 0,32.

Le réseau est un réseau plan comportant environ 1200 traits au millimètre.

Le système optique 9 a une focale de 6 mm.

Différentes modifications du procédé de réglage et de la source sont envisageables sans sortir du domaine de l'invention, en particulier le système optique 9 peut avantageusement être un système catadioptrique.

Les signes de référence insérés après les caractéristiques techniques mentionnées dans les revendications, ont pour seul but de faciliter la compréhension de ces dernières, et n'en limitent aucunement la portée.

## Revendications

1. Procédé de réglage d'une source lumineuse à cavité étendue continûment syntonisable,

   ladite source comprenant :

   - un laser (1) commandé par un courant injecté, ayant un axe optique (3) et une première et une deuxième faces (4, 5), la première face (4) ayant un faible coefficient de réflexion ;
   - un réseau de diffraction (7) placé sur l'axe (3) du laser (1), du côté de la première face (4), translatable le long de l'axe (3) du laser et orientable autour d'un axe (8) coupant l'axe (3) du laser à angle droit, et formant, avec la deuxième face (5) du laser (1), la cavité étendue ;
   - un bras (10) rigidement lié au réseau (7), ayant une extrémité (11) mobile en contact permanent avec un plan de glissement (12) perpendiculaire à l'axe optique (3) du laser (1) ;
   - des moyens (13) de réglage fin du plan de glissement (12) par rapport au laser (1) ;

   la syntonisation de la source étant obtenue par un déplacement du réseau (7),
      caractérisé en ce que :

   a) on fait un réglage approximatif de l'orientation et de la position du plan de glissement (12) ;
   b) on fait tourner le réseau (7) et, simultanément, on mesure la puissance d'émission de la source par rapport au courant injecté, en fonction du déplacement du réseau (7) ;
   c) on compte le nombre de sauts de la puissance d'émission par rapport au courant injecté au cours du déplacement du réseau, chaque saut étant affecté d'un signe fonction de son sens ;

d) on agit sur les moyens de réglage fin (13) en fonction du résultat du comptage ;

e) on répète les opérations b), c) et d), jusqu'à ce que le résultat du comptage soit nul.

2. Procédé de réglage d'une source lumineuse à cavité étendue continûment syntonisable selon la revendication 1, caractérisé en ce que :

- on compte le nombre de sauts, indépendamment de leur sens ;
- on agit sur les moyens de réglage fin (13), jusqu'à ce que le nombre de sauts soit nul.

3. Procédé de réglage d'une source lumineuse à cavité étendue continûment syntonisable selon l'une quelconque des revendications 1 à 2, caractérisé en ce que la mesure de la puissance d'émission est faite par prélèvement d'une partie du flux lumineux émis.

4. Procédé de réglage d'une source lumineuse à cavité étendue continûment syntonisable selon l'une quelconque des revendications 1 à 3, caractérisé en ce que la puissance d'émission de la source lumineuse est asservie à une valeur constante, et en ce que l'on mesure le courant injecté, commandant le laser.

5. Procédé de réglage d'une source lumineuse à cavité étendue continûment syntonisable selon l'une quelconque des revendications 1 à 4, caractérisé en ce que le réglage est automatisé, les moyens de réglage fin (13) étant actionnés par des moyens automatiques à partir de la puissance d'émission par rapport au courant injecté.

6. Procédé de réglage d'une source lumineuse à cavité étendue continûment syntonisable selon l'une quelconque des revendications 1 à 5, caractérisé en ce que le réglage est assuré en permanence pendant le fonctionnement de la source.

7. Source lumineuse continûment syntonisable à cavité étendue, comprenant :

- un laser (1) commandé par un courant injecté, ayant un axe optique (3) et une première et une deuxième faces (4, 5), la première face (4) ayant un faible coefficient de réflexion ;
- un réseau de diffraction (7) placé sur l'axe (3) du laser (1), du côté de la première face (4), translatable le long de l'axe (3) du laser et orientable autour d'un axe (8) coupant l'axe (3) du laser à angle droit, et formant, avec la deuxième face (5) du laser (1), la cavité étendue ;

- un bras (10) rigidement lié au réseau (7) ayant une extrémité (11) mobile qui est en contact permanent avec un plan de glissement (12) perpendiculaire à l'axe optique (3) du laser (1) ;
- des moyens (13) de réglage fin du plan de glissement (12) par rapport au laser (1) ;

la syntonisation de la source étant obtenue par un déplacement du réseau (7),
caractérisée en ce qu'elle comporte :

- des moyens (14) de prélèvement d'une partie du flux émis ;
- un photodétecteur (15) recevant le flux prélevé ;
- des moyens de traitement (16) du signal électrique du photodétecteur ;
- des moyens de commande (17) des moyens de réglage fin (13) à partir d'un signal élaboré par les moyens de traitement,

lors du réglage, les moyens de traitement (16) asservissant la puissance d'émission à une valeur fixe, en :

a) engendrant le déplacement du réseau (7) ;

b) mesurant simultanément la puissance d'émission de la source ;

c) comptant le nombre de sauts de la puissance d'émission par rapport au courant injecté au cours de la rotation du réseau, chaque saut étant affecté d'un signe fonction de son sens ;

d) agissant sur les moyens de réglage fin (13) en fonction du résultat du comptage ;

e) reproduisant les opérations a) à d), jusqu'à ce que le résultat du comptage soit nul ;

f) comptent le nombre de sauts, indépendamment de leur sens ;

g) agissent sur les moyens de commande, jusqu'à ce que le nombre de sauts soit nul.


**Patentansprüche**

1. Verfahren zum Justieren einer kontinuierlich abstimmbaren Lichtquelle mit erweitertem Resonator, wobei die Quelle aufweist:

- einen durch einen injizierten Strom gesteuerten Laser (1) mit einer optischen Achse (3) und einer ersten und einer zweiten Fläche (4, 5), wobei die erste Fläche (4) einen geringen Reflektionskoeffizienten hat;

- ein in der Achse (3) des Lasers (1) auf der Seite der ersten Fläche (4) angeordnetes Beugungsgitter (7), das entlang der Achse (3) des Lasers verschiebbar und um eine die Achse (3) des Lasers in rechtem Winkel schneidende Achse (8) ausrichtbar ist, und das mit der zweiten Fläche (5) des Lasers (1) den erweiterten Resonator bildet;

- einen starr mit dem Gitter (7) verbundenen Arm (10) mit einem bewegbaren Ende (11), das in permanentem Kontakt mit einer zur optischen Achse (3) des Lasers (1) senkrechten Gleitebene (12) steht;

- eine Einrichtung (13) zur Feinjustierung der Gleitebene (12) in bezug auf den Laser (1);

wobei die Abstimmung der Quelle durch Verschieben des Gitters (7) erfolgt,
dadurch gekennzeichnet, daß:

a) eine annähernde Justierung der Ausrichtung und der Position der Gleitebene (12) durchgeführt wird;

b) das Gitter (7) gedreht und gleichzeitig die Emissionsleistung der Quelle in bezug zum injizierten Strom als Funktion der Verschiebung des Gitters (7) gemessen wird;

c) die Zahl der Emissionsleistungssprünge in bezug auf den injizierten Strom während des Verschiebens des Gitters gezählt wird, wobei jedem Sprung ein von seiner Richtung abhängiges Vorzeichen zugeordnet wird;

d) die Feinjustierungseinrichtung (13) in Abhängigkeit von dem Zählergebnis betätigt wird;

e) die Schritte b), c) und d) wiederholt werden, bis das Ergebnis des Zählvorgangs Null ist.

2. Verfahren zum Justieren einer kontinuierlich abstimmbaren Lichtquelle mit erweitertem Resonator nach Anspruch 1, dadurch gekennzeichnet, daß

- die Zahl der Sprünge unabhängig von ihrer Richtung gezählt wird;

- die Feinjustierungseinrichtung (13) so lange betätigt wird, bis die Zahl der Sprünge Null ist.

3. Verfahren zum Justieren einer kontinuierlich abstimmbaren Lichtquelle mit erweitertem Resonator nach einem der Ansprüche 1 bis 2, dadurch gekennzeichnet, daß die Messung der Emissionsleistung durch Abgreifen eines Teils des emittierten Lichtflusses erfolgt.

4. Verfahren zum Justieren einer kontinuierlich abstimmbaren Lichtquelle mit erweitertem Resonator nach einem der Ansprüche 1 bis 3, dadurch gekennzeichnet, daß die Emissionsleistung der Lichtquelle auf einen konstanten Wert geregelt wird, und daß der den Laser steuernde injizierte Strom gemessen wird.

5. Verfahren zum Justieren einer kontinuierlich abstimmbaren Lichtquelle mit erweitertem Resonator nach einem der Ansprüche 1 bis 4, dadurch gekennzeichnet, daß die Justierung automatisiert ist, wobei die Feinjustierungseinrichtung (13) durch eine automatische Einrichtung ausgehend von der Emissionsleistung in bezug zum injizierten Strom betätigt wird.

6. Verfahren zum Justieren einer kontinuierlich abstimmbaren Lichtquelle mit erweitertem Resonator nach einem der Ansprüche 1 bis 5, dadurch gekennzeichnet, daß die Justierung während des Betriebs der Quelle fortlaufend gewährleistet ist.

7. Kontinuierlich abstimmbare Lichtquelle mit erweitertem Resonator, mit:

- einem durch einen injizierten Strom gesteuerten Laser (1) mit einer optischen Achse (3) und einer ersten und einer zweiten Fläche (4, 5), wobei die erste Fläche (4) einen geringen Reflektionskoeffizienten hat;

- einem in der Achse (3) des Lasers (1) auf der Seite der ersten Fläche (4) angeordneten Beugungsgitter (7), das entlang der Achse (3) des Lasers verschiebbar und um eine die Achse (3) des Lasers in rechtem Winkel schneidende Achse (8) ausrichtbar ist, und das mit der zweiten Fläche (5) des Lasers (1) den erweiterten Resonator bildet;

- einem starr mit dem Gitter (7) verbundenen Arm (10) mit einem bewegbaren Ende (11), das in permanentem Kontakt mit einer zur optischen Achse (3) des Lasers (1) senkrechten Gleitebene (12) steht;

- einer Einrichtung (13) zur Feinjustierung der Gleitebene (12) in bezug auf den Laser (1);

- wobei die Abstimmung der Quelle durch Verschieben des Gitters (7) erfolgt,

dadurch gekennzeichnet, daß sie aufweist:

- eine Einrichtung (14) zum Abgreifen eines Teils des emittierten Flusses;

- einen Photodetektor (15), der den abgegriffenen Fluß empfängt;

- eine Einrichtung (16) zum Verarbeiten des elektrischen Signals des Photodetektors;

- eine Einrichtung (17) zum Steuern der Feinjustierungseinrichtung (13) ausgehend von einem von der Verarbeitungseinrichtung erstellten Signal,

wobei die Verarbeitungseinrichtung (16) die Emissionsleistung während des Justierens auf einen festen Wert regelt, durch:

a) Bewirken der Verschiebung des Gitters (7);

b) gleichzeitiges Messen der Emissionsleistung der Quelle;

c) Zählen der Emissionsleistungssprünge in bezug auf den injizierten Strom während des Drehens des Gitters, wobei jedem Sprung ein von seiner Richtung abhängiges Vorzeichen zugeordnet wird;

d) Betätigen der Feinjustierungseinrichtung (13) in Abhängigkeit vom Ergebnis des Zählvorgangs;

e) Wiederholen der Schritte a) bis d) bis das Ergebnis des Zählvorgangs Null ist;

f) Zählen der Sprünge unabhängig von ihrer Richtung;

g) Betätigen der Feinjustierungseinrichtung (13) bis die Zahl der Sprünge Null ist.

## Claims

1. A method of adjustment of a continuously tunable high cavity light source, said source comprising:

   - a laser (1) controlled by an injected current with an optical axis (3) and a first and a second face (4,5) the first face (4) having a low reflection coefficient,
   - a diffraction grating (7) located on the axis (3) of the laser (1), on the side of the first face (4), moveable along the axis (3) of the laser and adjustable about an axis (8) intersecting the laser axis (3) at right-angles and with the second face (5) of the laser (1), forming the high cavity,
   - an arm (10) rigidly connected to the grating (7) having a mobile end (11) which is in permanent contact with a slide plane (12) perpendicular to the optical axis (3) of the laser (1),
   - means (13) of fine adjustment of the slide plane (12) with respect to the laser (1),

   the tuning of the source being achieved by a shifting of the grating (7)
   characterized in that:

   (a) an approximate adjustment is made of the orientation and position of the slide plane (12),
   (b) the grating (7) is rotated and, simultaneously, the emissive power of the source is measured with respect to the current injected as a function of the moving of the grating (7),
   (c) the number of emissive power jumps is counted with respect to the current injected during the moving of the grating, each jump being given a sign depending on its direction,
   (d) the fine adjustment means (13) are used in accordance with the result of the count,
   (e) operations (b), (c) and (d) are repeated until the count result is zero.

2. Method of adjustment of a continuously tunable high cavity light source according to claim 1, characterized in that:

   - the number of jumps is counted, independent of their direction,
   - the fine adjustment means (13) are used until the number of jumps is zero.

3. Method of adjustment of a continuously tunable high cavity light source according to any one of claims 1 and 2, characterized in that the emissive power is measured by sampling a portion of the light flux emitted.

4. Method of adjustment of a continuously tunable high cavity light source according to any one of claims 1 to 3, characterized in that the emissive power of the light source is locked at a constant value, and that the current injected, controlling the laser, is measured.

5. Method of adjustment of a continuously tunable high cavity light source according to any one of claims 1 to 4, characterized in that the adjustment is automated, the fine adjustment means (13) being actuated by automatic means based on the emissive power with respect to the current injected.

6. Method of adjustment of a continuously tunable high cavity light source according to any one of claims 1 to 5, characterized in that the adjustment is made permanently during the operation of the source.

7. Continuously tunable high cavity light source comprising:

- a laser (1) controlled by an injected current with an optical axis (3) and a first and a second face (4,5), the first face (4) having a low reflection coefficient,
- a diffraction grating (7) located on the axis (3) of the laser (1), on the side of the first face (4), moveable along the axis (3) of the laser and adjustable about an axis (8) intersecting the laser axis (3) at right-angles, and, with the second face (5) of the laser (1), forming the high cavity,
- an arm (10) rigidly connected to the grating (7) having a mobile end (11) which is in permanent contact with a slide plane (12) perpendicular to the optical axis (3) of the laser (1),
- means (13) of fine adjustment of the slide plane (12) with respect to the laser (1),
- the tuning of the source being achieved by a shifting of the grating (7),

    characterized in that it comprises:

- means (14) of sampling a portion of the flux emitted,
- a photodetector (15) receiving the sampled flux,
- means (16) of processing the electric signal from the photodetector,
- means (17) of controlling the fine adjustment means (13) based on a signal generated by the processing means, during the adjustment, the processing means (16) locking the emissive power at a fixed value, by:

    (a) causing the moving of the grating (7),
    (b) simultaneously measuring the emissive power of the source,
    (c) counting the number of jumps of emissive power with respect to the current injected during the rotation of the grating, each jump being given a sign depending on its direction,
    (d) acting on the fine adjustment means (13) in accordance with the result of the count,
    (e) repeating operations (a) to (d) until the result of the count is zero,
    (f) counting the number of jumps, independent of their direction,
    (g) acting on the control means until the number of jumps is zero.

FIG.1

FIG.2

FIG.3

FIG.4

FIG.5

FIG. 6

FIG. 7